Europäisches Patentamt

European Patent Office

Office européen des brevets

(11) Publication number: **0 272 924 B1**

# EUROPEAN PATENT SPECIFICATION

(45) Date of publication of patent specification: **30.10.91**    (51) Int. Cl.⁵: **H03K 3/02, H03K 5/04**

(21) Application number: **87311334.4**

(22) Date of filing: **22.12.87**

(54) Pulse generator.

(30) Priority: **22.12.86 IT 2279986**

(43) Date of publication of application:
**29.06.88 Bulletin 88/26**

(45) Publication of the grant of the patent:
**30.10.91 Bulletin 91/44**

(84) Designated Contracting States:
**DE FR GB NL SE**

(56) References cited:
**US-A- 4 338 527**

**ELEKTRONIK vol.33, no. 16, 10 August 1984,
pages 40-44, DE; H. SAX: "Tachoregelung
ohne Tachogenerator"**

(73) Proprietor: **SGS-THOMSON MICROELECTRON-
ICS s.r.l.
Via C. Olivetti, 2
I-20041 Agrate Brianza MI(IT)**

(72) Inventor: **Poletto, Vanni
Via Serra, 82
I-15020 Camino (AL)(IT)**

(74) Representative: **Robinson, John Stuart et al
Marks & Clerk Alpha Tower Suffolk Street
Queensway
Birmingham, B1 1TT(GB)**

## Description

The present invention relates to current pulse generator circuits, for instance for the generation of current pulses of extremely short duration for use in monolithically integrated devices using technology of bipolar type with separate supplies.

The pulse generator circuits which are conventionally used in monolithically integrated devices generally comprise a capacitor whose charging and subsequent discharging are controlled by transistors which operate as switches, switching from a cut-off state to a conductive state and vice versa. In the conductive state, the transistors operate at saturation in such a way that this state is in effect accurately defined. A typical example of such pulse generator circuits is incorporated in the monolithically integrated device having the abbreviation TDA 7272 produced by the applicants. If the components of the circuit are normally dimensioned, current pulses having a duration in the microsecond ($\mu$s) range are obtained.

The most recent embodiments of monolithically integrated circuits for use with telephones, for example interface circuits between exchange components and subscribers' telephone lines, have led to the problem of inserting known pulse generator circuits in integrated devices having two separate supplies simultaneously, one for circuit components operating with voltages of approximately 50 V and the other for circuit components operating with low voltages of approximately 5 V. Since in these devices the substrate of semiconductor material of the integrated circuit is biased to approximately -50 V with respect to a reference potential, the presence of transistors in saturation in the pulse generator circuits in circuit components supplied with a low voltage leads, despite the conventional isolation devices, to considerable supply current consumption which is discharged through the substrate thereby causing dissipation problems. Circuit and technological devices to prevent this loss of current through the substrate would entail a considerable increase in integration area occupation and a reduction of the speed of operation, i.e. the opposite of the requirements for such telephone circuits.

According to first and second aspects of the invention, there are provided pulse generator circuits as defined in the appended Claims 1 and 2, respectively. Preferred embodiments of the invention are defined in the other appended claims.

It is thus possible to provide a circuit for the generation of current pulses of extremely short duration which can be monolithically integrated using technology of bipolar type and which can be adapted to a wide variety of applications with respect to known circuits.

The invention will be further described, by way of example, with reference to the accompanying drawings, in which :

Figure 1 is a diagram of a current pulse generator circuit consistituting a first preferred embodiment of the invention; and

Figure 2 is a diagram of a current pulse generator circuit constituting a second preferred embodiment of the invention which is simplified with respect to the embodiment of Figure 1.

The same reference letters and numerals have been used in the figures for corresponding components.

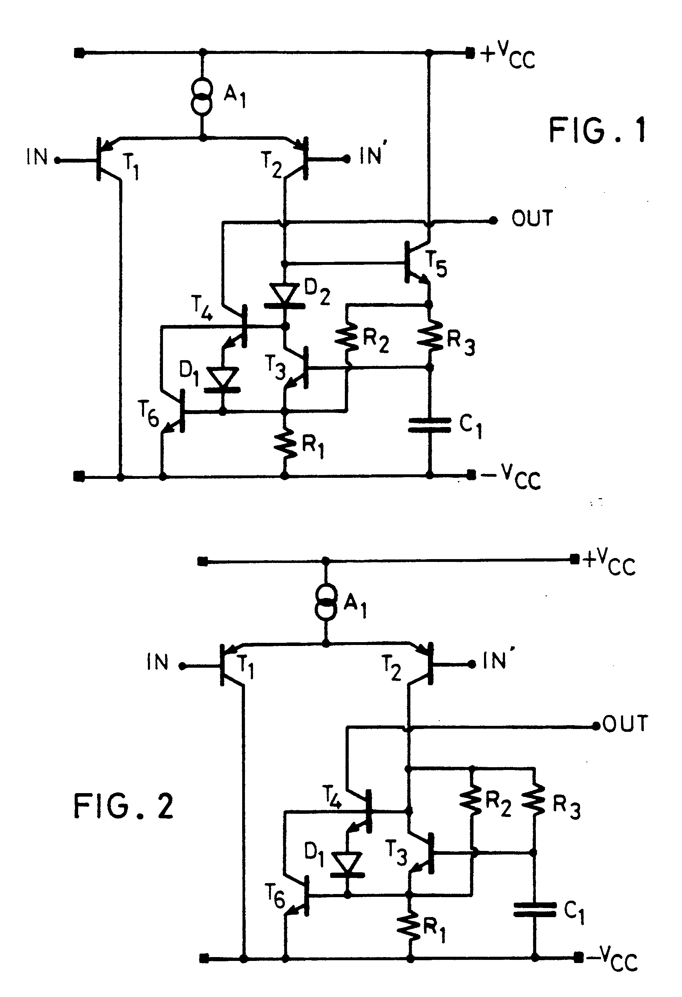

The current pulse generator circuit shown in Figure 1 comprises first and second bipolar transistors T1 and T2 of p-n-p type, whose emitter terminals are both connected to the positive pole +Vcc of a supply voltage source via a constant current generator A1. The base terminal of the transistor T1 and the base terminal of the transistor T2 form first and second input terminals IN and IN', respectively, of the circuit. The collector terminal of the transistor T1 is connected to the negative pole -Vcc of the supply voltage source.

The circuit also comprises third, fourth, fifth and sixth bipolar transistors T3, T4, T5 and T6, each of n-p-n type, and first and second diodes D1 and D2. The emitter terminal of the transistor T3 is connected to the negative pole -Vcc via a first resistor R1, to the emitter terminal of the transistor T4 via the diode D1, to the emitter terminal of the transistor T5 via a second resistor R2, and to the base terminal of the transistor T6. The collector terminal of the transistor T3 is connected via the diode D2 both to the collector terminal of the transistor T2 and the base terminal of the transistor T5, and is also connected to the base terminal of the transistor T4 and to the collector terminal of the transistor T6. The base terminal of the transistor T3 is connected to the emitter terminal of the transistor T5 via a third resistor R3 and to the negative -Vcc via a capacitor C1.

The emitter terminal of the transistor T6 is connected to the negative pole -Vcc and the collector terminal of the transistor T5 is connected to the positive pole +Vcc.

The collector terminal of the transistor T4 forms an output terminal (OUT) of the circuit.

The operation of the circuit will now be described for a conventional type of use.

The base terminal of the transistor T2 is connected to a reference voltage source, with a typical value of 1.2 V, while a voltage signal having a rectangular wave shape, which alternates between two values on either side of the reference voltage value, is supplied to the base terminal of the transistor T1. At each leading edge where the signal changes from the lower voltage value to the higher value, the transistor T1, which was initially conductive, is cut off, while the transistor T2, which was previously cut off, starts to conduct. The collector current of the transistor T2 begins to flow directly into the base of the transistor T5 and via the diode D2 into the base of the transistor T4, thereby causing these transistors to conduct. The emitter current of the transistor T4 which flows into the base of the transistor T6 via the diode D1 brings into conduction the transistor T6 which begins to absorb, via the transistor T2 and the diode D2, the current generated by the generator A1.

The value of the current passing through the resistor R1 is then equal to $V_{BE6}/R1$ , where $V_{BE6}$ is the base-emitter voltage of the transistor T6. This current value determines the amplitude of the current pulse generated by the transistor T4 in a load (not shown) connected to the output terminal OUT. The current flowing through the diode D1 is equal, less a negligible current via the resistor R2, to the current set in the resistor R1 by the voltage $V_{BE6}$ of the transistor T6 in conduction.

The capacitor C1, which is initially discharged, prevents the immediate conduction of the transistor T3. The capacitor C1, however, immediately begins to be charged by the current flowing through the resistor R3, giving a voltage across the capacitor terminals which tends exponentially towards a value almost equal to that of the voltage at the emitter terminal of the transistor T5 which is roughly equal to the sum of the base-emitter voltages of the transistors T4 and T6 plus the junction voltage of the diode D1.

As soon as the voltage across the terminals of the capacitor C1 reaches a value equal to double the base-emitter voltage of a bipolar transistor in conduction, the transistor T3 starts to conduct and causes the transistor T4 to be cut off by absorbing all the current passing through the diode D2. The transistor T6 also helps to deplete the charges in the base of T4. The switching transient of the transistor T3 from the cut off state to the state of full conduction is extremely rapid despite the presence of the capacitor C1 which prevents a rapid variation of the base-emitter voltage of this transistor.

During the switch-on transient of the transistor T3, the transistor T6 continues reliably to conduct while the cut-off transient of the transistor T1 begins, causing a decrease in the flow of current through the diode D1.

Since the current via the resistor R1 must in practice remain constant for the state of conduction of the transistor T6 which sets a voltage equal to its base-emitter voltage across the terminals of the resistor, the transistor T3 is compelled to increase its emitter current to make up for the drop in the current supplied by the transistor T4. In this way both the switch-on of the transistor T3 and the cut off of the transistor T4 are accelerated as a result of the positive feedback which is created between the two transistors. It is the rapidity of switching of this pair of transistors, due precisely to their close connection, which enables the circuit to generate pulses of extremely short duration.

The time lapse between the leading edge of the input signal and the instant at which the transistor T3 begins to conduct is roughly equal to the product of the capacitance of the capacitor C1 and the value of the resistor R3. The achievement of current pulses of very short duration in time can therefore be reconciled with the requirements of monlithic integration of a practical semiconductor device including the circuit, since smaller resistance and capacitance values are required.

The state of the circuit in which the transistor T4 is cut off and the transistors T3 and T5 are conducting continues until the subsequent trailing edge of the input signal, when the conduction of the transistor T1 and the cutting off of the transistor T2 cause, until the following leading edge of the input signal, all of the other transistors of the circuit to be cut off.

The resistor R2 is designed to bias the transistor T5 when the transistor T4 is cut off and, together with the resistors R1 and R3, is designed to discharge the capacitor C1 such that the circuit is in the initial state when the input signal supplies a further leading edge.

The transistor T6 is not essential for the operation of the circuit, since its function is chiefly to regulate the amplitude of the current pulses in applications in which this is necessary. For this reason, the circuit can also be constructed without the transistor T6 and therefore without the associated connections.

When the transistor T6 is provided, the resistor R1 may be dimensioned such that the switching on of the transistor T3 causes the transistor T6 to be cut off as well, although this cut off is not indispensable for the correct operation of the circuit.

If a signal with a rectangular wave shape is supplied to the base terminal of the transistor T1, a sequence of pulses corresponding to the leading edges of the input signal is therefore obtained as output. If, however, the signal is supplied to the base terminal of the transistor T2 and the base terminal of the transistor T1 is connected to receive a reference voltage, a sequence of output pulses corresponding to the trailing edges of the input signal is obtained.

A circuit of the type shown in Figure 1 may generate, when its components are normally dimensioned, current pulses with a predetermined amplitude of extremely short duration, less than 100 nanoseconds (ns). None of the transistors included in the circuit has to operate in saturation, and there is therefore full adaptability even to integrated devices with dual supplies of the telephone type.

A simplified embodiment is shown in Figure 2. The transistor T5 and the diode D2 have been eliminated with respect to Figure 1; the collector terminal of the transistor T2 is directly connected to the base terminal of the transistor T4, to the collector terminal of the transistor T3, to the collector terminal of the transistor T6, and to the resistors R2 and R3.

In this simplified circuit, however, the value of the current generated by the generator A1 must be higher to enable the switching on of the transistor T3 because, when the capacitor C1 begins to be charged and the voltage across its terminals is therefore much lower, a substantial proportion of the current generated by the generator A1 must flow into the resistor R3. The transistor T6 is not essential for the correct operation of the circuit in this case either and is substantially designed to regulate the amplitude of the pulses.

Various modifications may be made within the scope of the invention as claimed : for instance, the types of polarity of the bipolar transistors could be exchanged or field effect transistors could be used.

## Claims

1. A current pulse generator circuit comprising first and second transistors (T1, T2) of a first type of conductivity and each having first and second terminals and a control terminal, the first terminal of the first transistor (T1) and the first terminal of the second transistor (T2) being connected together and via a constant current generator (A1) to a first supply terminal (+Vcc), the second terminal of the first transistor (T1) being connected to a second supply terminal (-Vcc), the control terminals of the first and second transistors (T1, T2) forming first and second input terminals (IN, IN'), respectively, characterized in that the circuit comprises third, fourth and fifth transistors (T3, T4, T5) of a second type of conductivity opposite to the first and each having first and second terminals and a control terminal, the first terminal of the third transistor (T3) being connected to the second supply terminal (-Vcc) via a first resistor (R1), to the first terminal of the fourth transistor (T4) via a first diode (D1), and to the first terminal of the fifth transistor (T5) via a second resistor (R2), the second terminal of the third transistor (T3) being connected via a second diode (D2) to the second terminal of the second transistor (T2) and to the control terminal of the fifth transistor (T5) and being connected to the control terminal of the fourth transistor (T4), the control terminal of the third transistor (T3) being connected to the first terminal of the fifth transistor (T5) via a third resistor (R3) and to the second supply terminal (-Vcc) via a capacitor (C1), the second terminal of the fifth transistor (T5) being connected to the first supply terminal (+Vcc) and the second terminal of the fourth transistor (T4) forming an output terminal (OUT) of the circuit.

2. A current pulse generator circuit comprising first and second transistors (T1, T2) of a first type of conductivity and each having first and second terminals and a control terminal, the first terminal of the first transistor (T1) and the first terminal of the second transistor (T2) being connected together and via a constant current generator (A1) to a first supply terminal (+Vcc), the second terminal of the first transistor (T1) being connected to a second supply terminal (-Vcc), the control terminals of the first and second transistors (T1, T2) forming first and second input terminals (IN, IN'), respectively, characterized in that the circuit comprises third and fourth transistors (T3, T4) of a second type of conductivity opposite to the first and each having first and second terminals and a control terminal, the first terminal of the third transistor (T3) being connected to the second supply terminal (-Vcc) via a first resistor (R1), to the first terminal of the fourth transistor (T4) via a diode (D1), and to the second terminal of the second transistor (T2) via a second resistor (R2), the second terminal of the third transistor (T3) being connected to the second terminal of the second transistor (T2) and to the control terminal of the fourth transistor (T4), the control terminal of the third transistor (T3) being connected to the second terminal of the second transistor (T2) via a third resistor (R3) and to the second supply terminal (-Vcc) via a capacitor (C1), the second terminal of the fourth transistor (T4) forming an output terminal (OUT) of the circuit.

3. A current pulse generator circuit as claimed in Claim 1 or 2, characterized in that it comprises a further transistor (T6) of the second type of conductivity and having first, second and control terminals connected to the second supply terminal (-Vcc), to the second terminal of the third transistor (T3), and to the first terminal of the third transistor (T3), respectively.

4. A current pulse generator circuit as claimed in any one of the preceding claims, characterized in that the transistors included therein are bipolar transistors, the first, second and control terminals of each of which are the emitter, collector and base, respectively.

5. A monolithically integrated circuit characterized by including a current pulse generator circuit as claimed in any one of the preceding claims.

**Revendications**

1. Circuit générateur d'impulsions de courant, comprenant des premier et deuxième transistors (T1, T2) d'un premier type de conductivité, comportant chacun des première et seconde bornes et une borne de commande, la première borne du premier transistor (T1) et la première borne du deuxième transistor (T2) étant raccordées ensemble et par l'intermédiaire d'un générateur de courant constant (A1) à une première borne d'alimentation (+Vcc), la seconde borne du premier transistor (T1) étant raccordée à une seconde borne d'alimentation (-Vcc), les bornes de commande des premier et deuxième transistors (T1, T2) constituant respectivement des première et seconde bornes d'entrée (IN, IN'), caractérisé en ce que le circuit comprend des troisième, quatrième et cinquième transistors (T3, T4, T5) d'un second type de conductivité opposé au premier, comportant chacun des première et seconde bornes et une borne de commande, la première borne du troisième transistor (T3) étant raccordée à la seconde borne d'alimentation (-Vcc) par l'intermédiaire d'une première résistance (R1), à la première borne du quatrième transistor (T4) par l'intermédiaire d'une première diode (D1) et à la première borne du cinquième transistor (T5) par l'intermédiaire d'une deuxième résistance (R2), la seconde borne du troisième transistor (T3) étant raccordée par l'intermédiaire d'une seconde diode (D2) à la seconde borne du deuxième transistor (T2) et à la borne de commande du cinquième transistor (T5) et étant raccordée à la borne de commande du quatrième transistor (T4), la borne de commande du troisième transistor (T3) étant raccordée à la première borne du cinquième transistor (T5) par l'intermédiaire d'une troisième résistance (R3) et à la seconde borne d'alimentation (-Vcc) par l'intermédiaire d'un condensateur (C1), la seconde borne du cinquième transistor (T5) étant raccordée à la première borne d'alimentation (+Vcc) et la seconde borne du quatrième transistor (T4) constituant une borne de sortie (OUT) du circuit.

2. Circuit générateur d'impulsions de courant, comprenant des premier et deuxième transistors (T1, T2) d'un premier type de conductivité, comportant chacun des première et seconde bornes et une borne de commande, la première borne du premier transistor (T1) et la première borne du deuxième transistor (T2) étant raccordées ensemble et par l'intermédiaire d'un générateur de courant constant (A1) à une première borne d'alimentation (+Vcc), la seconde borne du premier transistor (T1) étant raccordée à une seconde borne d'alimentation (-Vcc), les bornes de commande des premier et deuxième transistors (T1, T2) constituant respectivement des première et seconde bornes d'entrée (IN, IN'), caractérisé en ce que le circuit comprend des troisième et quatrième transistors (T3, T4) d'un second type de conductivité opposé au premier, comportant chacun des première et secondes bornes et une borne de commande, la première borne du troisième transistor (T3) étant raccordée à la seconde borne d'alimentation (-Vcc) par l'intermédiaire d'une première résistance (R1), à la première borne du quatrième transistor (T4) par l'intermédiaire d'une diode (D1) et à la seconde borne du deuxième transistor (T2) par l'intermédiaire d'une deuxième résistance (R2), la seconde borne du troisième transistor (T3) étant raccordée à la seconde borne du deuxième transistor (T2) et à la borne de commande du quatrième transistor (T4), la borne de commande du troisième transistor (T3) étant raccordée à la seconde borne du deuxième transistor (T2) par l'intermédiaire d'une troisième résistance (R3) et à la seconde borne d'alimentation (-Vcc) par l'intermédiaire d'un condensateur (C1), la seconde borne du quatrième transistor (T4) constituant une borne de sortie (OUT) du circuit.

3. Circuit générateur d'impulsions de courant selon la revendication 1 ou 2, caractérisé en ce qu'il comprend un transistor supplémentaire (T6) du second type de conductivité, comportant des première et seconde bornes et une borne de commande, raccordees respectivement à la seconde borne d'alimentation (-Vcc), à la seconde borne du troisième transistor (T3) et a la première borne du troisième transistor (T3).

4. Circuit générateur d'impulsions de courant selon l'une quelconque des revendications 1 à 3, caractérisé en ce que les transistors qui y sont contenus sont des transistors bipolaires dont les première et seconde bornes et la borne de commande sont respectivement l'émetteur, le collecteur et la base.

5. Circuit intégré monolithiquement, caractérisé en ce qu'il contient un circuit générateur d'impulsions de courant selon l'une quelconque des revendications 1 à 4.

**Patentansprüche**

1. Stromimpulsgeneratorschaltung, mit einem ersten und zweiten Transistor (T1, T2) eines ersten Leitungstyps, wovon jeder eine erste und zweite Klemme und eine Steuerklemme hat, wobei die erste Klemme des ersten Transistors (T1) und die erste Klemme des zweiten Transistors (T2) miteinander verbunden sind und über einen Konstantstromgenerator (A1) an eine erste Stromversorgungsklemme (+Vcc) angeschlossen sind, die zweite Klemme des ersten Transistors (T1) an eine zweite Stromversorgungsklemme (-Vcc) angeschlossen ist, und die Steuerklemmen des ersten und des zweiten Transistors (T1, T2) jeweils eine erste und zweite Eingangsklemme (IN, IN') bilden, dadurch **gekennzeichnet,** dass die Schaltung einen dritten, vierten und fünften Transistor (T3, T4, T5) eines zweiten Leitungstyps aufweist, der dem ersten Leitungstyp entgegengerichtet ist, und jeder eine erste und zweite Klemme und eine Steuerklemme hat, die erste Klemme des dritten Transistors (T3) mit der zweiten Stromversorgungsklemme (-Vcc) über einen ersten Widerstand (R1) verbunden ist, mit der ersten Klemme des vierten Transistors (T4) über eine erste Diode (D1), und mit der ersten Klemme des fünften Transistors (T5) über einen zweiten Widerstand (R2), die zweite Klemme des dritten Transistors (T3) über eine zweite Diode (D2) mit der zweiten Klemme des zweiten Transistors (T2) und mit der Steuerklemme des fünften Transistors (T5) und mit der Steuerklemme des vierten Transistors (T4) verbunden ist, die Steuerklemme des dritten Transistors (T3) mit der ersten Klemme des fünften Transistors (T5) über einen dritten Widerstand (R3) und mit der zweiten Stromversorgungsklemme (-Vcc) über einen Kondensator (C1) verbunden ist, die zweite Klemme des fünften Transistors (T5) mit der ersten Stromversorgungsklemme (+Vcc) verbunden ist und die zweite Klemme des vierten Transistors (T4) eine Ausgangsklemme (OUT) der Schaltung bildet.

2. Stromimpulsgeneratorschaltung, mit einem ersten und einem zweiten Transistor (T1, T2) eines ersten Leitungstyps, wovon jeder eine erste und eine zweite Klemme und eine Steuerklemme hat, die erste Klemme des ersten Transistors (T1) und die erste Klemme des zweiten Transistors (T2) miteinander verbunden sind und über einen Konstantstromgenerator (A1) an eine erste Stromversorgungsklemme (+Vcc) angeschlossen sind, die zweite Klemme des ersten Transistors (T1) an eine zweite Stromversorgungsklemme (-Vcc) angeschlossen ist, und die Steuerklemmen des ersten und zweiten Transistors (T1, T2) jeweils eine erste und zweite Eingangsklemme (IN, IN') bilden, dadurch **gekennzeichnet,** dass die Schaltung einen dritten und vierten Transistor (T3, T4) eines zweiten Leitungstyps aufweist, der dem ersten entgegengesetzt ist und wovon jeder eine erste und zweite Klemme und eine Steuerklemme aufweist, die erste Klemme des dritten Transistors (T3) an die zweite Stromversorgungsklemme (-Vcc) über einen ersten Widerstand (R1) angeschlossen ist, an die erste Klemme des vierten Transistors (T4) über eine Diode (D1), und an die zweite Klemme des zweiten Transistors (T2) über einen zweiten Widerstand (R2), die zweite Klemme des dritten Transistors (T3) an die zweite Klemme des zweiten Transistors (T2) und an die Steuerklemme des vierten Transistors (T4) angeschlossen ist, die Steuerklemme des dritten Transistors (T3) an die zweite Klemme des zweiten Transistors (T2) über einen dritten Widerstand (R3) angeschlossen ist und an die zweite Stromversorgungsklemme (-Vcc) über einen Kondensator (C1), und die zweite Klemme des vierten Transistors (T4) eine Ausgangsklemme (OUT) der Schaltung bildet.

3. Stromimpulsgeneratorschaltung nach Anspruch 1 oder 2, dadurch **gekennzeichnet,** dass sie einen weiteren Transistor (T6) des zweiten Leitungstyps umfasst, der eine erste und zweite Klemme sowie eine Steuerklemme aufweist, die jeweils an die zweite Stromversorgungsklemme (-Vcc), an die zweite Klemme des dritten Transistors (T3) und an die erste Klemme des dritten Transistors (T3) angeschlossen ist.

4. Stromimpulsgeneratorschaltung nach irgendeinem der vorausgehenden Ansprüche, dadurch **gekennzeichnet,** dass die verwendeten Transistoren bipolare Transistoren sind, deren erste und zweite Klemme und deren Steuerklemme der Emitter, Kollektor und die Basis sind.

5. Monolithisch integrierte Schaltung, dadurch **gekennzeichnet,** dass sie eine Stromimpulsgeneratorschaltung nach irgendeinem der vorausgehenden Ansprüche aufweist.

FIG . 1

FIG . 2